# EUROPEAN PATENT APPLICATION

(11) **EP 4 723 477 A1**
(43) Date of publication of application: **08.04.2026**
(21) Application number: 24810498.6
(22) Date of filing: 25.05.2024
(51) Int. Cl.: H03H 9/05, H01P 1/207

(54) **CAVITY FILTER SYSTEM-IN-PACKAGE MODULE, ELECTRONIC PRODUCT, AND PREPARATION METHOD**

(30) Priority: 25.05.2023 CN 202310600855
(71) Applicant: Vanchip (Tianjin) Technology Co. Ltd, Tianjin 300457 (CN)
(72) Inventor: ZHANG, Lei, Tianjin 300457 (CN); XU, Xian, Tianjin 300457 (CN); ZHANG, Xinyao, Tianjin 300457 (CN); JIANG, Pinfang, Tianjin 300457 (CN); LIN, Hongkuan, Tianjin 300457 (CN)
(74) Representative: Wang, Bo
(86) International application number: PCT/CN2024/095366
(87) International publication number: WO 2024/240263

(57) **Abstract**

Disclosed in the present invention are a cavity filter system-in-package module, an electronic product, and a preparation method. The cavity filter system-in-package module comprises a substrate, a first flip chip, a second flip device, a film layer, and a plastic encapsulant, wherein the substrate is provided with a groove, which extends from an upper surface of the substrate towards the interior of the substrate down to the layer where a second layer pattern is located or below; the first flip chip is mounted or soldered within the groove; the second flip device is mounted or soldered on the upper surface of the substrate; the first flip chip and the second flip device are surrounded by a solder mask layer; and a continuous film layer is formed on the surface of the first flip chip and the solder mask layer, and the film layer on the surface of the second flip device and the solder mask layer is discontinuous. The present invention can improve the module reliability, and involve a simple process and have low costs.

## Description

### BACKGROUND

### Technical Field

The present invention relates to a cavity filter system-in-package module, to an electronic product including the cavity filter system-in-package module, and to a preparation method of the cavity filter system-in-package module, and belongs to the technical field of semiconductor packaging.

### Related Art

In a wireless network, when data needs to be transmitted, user equipment needs to continuously monitor physical downlink control channels, and receive and transmit the data based on instruction messages sent by network sides, which results in high power consumption of the user equipment and a significant delay of data transmission. Therefore, a 3GPP protocol introduces a discontinuous reception (Drx for short) mechanism energy saving strategy in an LTE system, and defines media access control in a physical layer. Therefore, a radio frequency front end for the 5G includes a diversity reception path, which is essentially a reception path, and is used to assist a primary receiver in signal reception.

A conventional diversity reception module includes a plurality of filter chips. A method of film covering is usually used to isolate an external molding compound to ensure that a cavity is formed at the bottom of a filter. However, the bottom of other chips or devices in the module cannot be well filled due to impact of the film covering, which easily causes a solder-bridging short circuit between the devices. In addition, because non-filter chips or devices are insufficiently filled with the molding compound, reliability of the non-filter chips or devices cannot be ensured.

### SUMMARY

A primary technical problem to be resolved by the present invention is to provide a cavity filter system-in-package module.

Another technical problem to be resolved by the present invention is to provide a preparation method of a cavity filter system-in-package module.

Still another technical problem to be resolved by the present invention is to provide an electronic product including a cavity filter system-in-package module.

To achieve the foregoing technical objectives, the present invention adopts the following technical solutions:
According to a first aspect of an embodiment of the present invention, a cavity filter system-in-package module is provided, including a substrate, a first flip chip, a second flip device, a film layer, and a plastic encapsulant, wherein
the substrate is provided with a groove, and the groove extends from an upper surface of the substrate toward an interior of the substrate down to or below a layer at which a second layer pattern is located;
the first flip chip is mounted or soldered in the groove;
the second flip device is mounted or soldered on the upper surface of the substrate;
a solder mask layer is disposed surrounding the first flip chip and the second flip device; and
a continuous film layer is formed on the surface of the first flip chip and the solder mask layer, and a film layer on the surface of the second flip device and the solder mask layer is discontinuous.

Preferably, a gap is formed between the solder mask layer and the first flip chip, and the gap is smaller than a size of a filler in the plastic encapsulant.

Preferably, a distance is formed between the second flip device and the solder mask layer, and the distance is greater than the gap.

Preferably, the distance is adjusted based on a height of a protrusion of the second flip device, a size of an open window of the solder mask layer, and a thickness of the solder mask layer.

Preferably, the distance is greater than 20 µm.

Preferably, the cavity filter system-in-package module further includes a colloid filling the gap.

According to a second aspect of an embodiment of the present invention, a preparation method of a cavity filter system-in-package module is provided, including the following steps:
S11: Prepare a substrate having a groove, where the groove extends from an upper surface of the substrate toward an interior of the substrate down to or below a layer at which a second layer pattern is located.
S12: Prepare a first flip chip and a second flip device.
S13: Connect a bump of the first flip chip to a second conductive circuit in the groove, and fix the first flip chip in the groove.
S14: Solder the second flip device to a second pad.
S15: Form a solder mask layer on the upper surface of the substrate, where the solder mask layer surrounds the first flip chip and the second flip device.
S16: Cover the solder mask layer, the first flip chip, and the second flip device with a film layer through a film covering process.
S17: Use a plastic sealing process to form a plastic encapsulant on the film layer.

According to a third aspect of an embodiment of the present invention, a preparation method of a cavity filter system-in-package module is provided, including the following steps:
S21: Prepare a substrate having a groove, where the groove extends from an upper surface of the substrate toward an interior of the substrate down to or below a layer at which a second layer pattern is located.
S22: Prepare a first flip chip and a second flip device.
S23: Connect a bump of the first flip chip to a second conductive circuit in the groove, and fix the first flip chip in the groove.
S24: Solder the second flip device to a second pad.
S25: Form a solder mask layer on the upper surface of the substrate, where the solder mask layer surrounds the first flip chip and the second flip device.
S26: Use a dispensing process to form a colloid between the first flip chip and the solder mask layer surrounding the first flip chip.
S27: Use a plastic sealing process to form a plastic encapsulant.

In step S27, the film layer is fractured by pressure from a molding compound.

According to a fourth aspect of an embodiment of the present invention, an electronic product is provided, including the foregoing cavity filter system-in-package module.

Compared with the prior art, the present invention has the following technical effects: A filter chip is soldered in a sink cavity formed by a solder mask layer of a substrate and Polypropylene (PP), a non-filter chip and a passive component are normally soldered on a pad on a surface layer of the substrate, and then a molding compound is used to selectively fill the non-filter chip and the passive component, which can ensure that a cavity can be formed at the bottom of the filter in the module, and the bottom of the non-filter chip and the bottom of the passive component can be well filled, thereby avoiding solder-bridging, and improving reliability of the module.

### BRIEF DESCRIPTION OF THE DRAWINGS

FIG. 1 is a schematic structural diagram of a cavity filter system-in-package module according to a first embodiment of the present invention;
FIG. 2A(a) to FIG. 2A(I) are a schematic diagram of a preparation procedure of a substrate of a cavity filter system-in-package module according to a second embodiment of the present invention;
FIG. 2B (a) to FIG. 2B (m) are a schematic diagram of a preparation procedure of a substrate of a cavity filter system-in-package module according to the second embodiment of the present invention;
FIG. 2C is a schematic diagram of a film covering procedure in a preparation method of a cavity filter system-in-package module according to the second embodiment of the present invention;
FIG. 2D is a schematic diagram of a plastic sealing procedure in a preparation method of a cavity filter system-in-package module according to the second embodiment of the present invention;
FIG. 2E is a top view of a substrate from which the first flip chip and the second flip device are removed before the film covering in FIG. 2C;
FIG. 3A is a schematic diagram of a dispensing procedure in a preparation method of a cavity filter system-in-package module according to a third embodiment of the present invention; and
FIG. 3B is a schematic diagram of a plastic sealing procedure in a preparation method of a cavity filter system-in-package module according to the third embodiment of the present invention.

### DETAILED DESCRIPTION

The technical content of the present invention is described in detail below with reference to the accompanying drawings and specific embodiments.

### First embodiment:

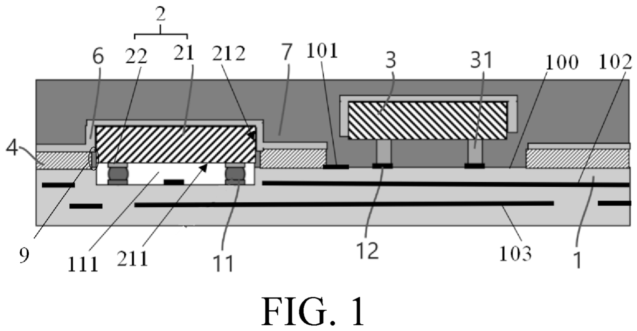

As shown in FIG. 1, a cavity filter system-in-package module provided in a first embodiment of the present invention includes a substrate 1, a first flip chip 2, a second flip device 3, a film layer 6, and a plastic encapsulant 7. The first flip chip 2 and the second flip device 3 are both flip chips (Flip Chip), to be specific, a protrusion of the chip is connected downward to the substrate, a carrier, and a circuit board. The first flip chip 2 is a cavity filter chip, for example, a surface acoustic wave (SAW) filter chip or a bulk acoustic wave (BAW) filter chip. However, this does not constitute a limitation to the present invention. In addition, the second flip device may be a flip chip or a surface-mount component. The flip chip is used as an example for description herein.

Herein, the substrate 1 may be an organic substrate or an inorganic substrate such as a carrier, a circuit board, a ceramic substrate, or an FR-4 epoxy glass fabric substrate having a plurality of wiring layers. In this embodiment, a PP substrate is used as an example for description. The PP substrate is also referred to as a prepreg, and is usually composed of glass fabric (Glass fabric), resin (Resin), dicyandiamide (Dicyandiamide), accelerator (Accelerator), solvent (Solvent), additive (Additive), and the like.

In this embodiment, a three-layer substrate is used as an example for description, but a person skilled in the art may understand that the present invention can be implemented by using a substrate of three or more layers.

The substrate 1 includes a first layer pattern 101, a second layer pattern 102, a second pad 12, and a barrier layer 4. The substrate may further include a third layer pattern 103. A quantity of layers is not limited, and only needs to be greater than two layers. The first layer pattern 101 and the second pad 12 are formed on an upper surface 100 of the substrate 1 in a same process through a process such as plating or etching. In other words, a plurality of second pads 12 are formed using copper in a non-grooved area of a front surface 100 of the substrate 1, to connect to the second flip device 3. The first flip chip 2 and the second flip device 3 are soldered to the upper surface 100 of the substrate 1. The barrier layer 4 is formed on the upper surface 100 and surrounds the first flip chip 2 and the second flip device 3.

In addition, the substrate 1 further includes a groove 111. The groove 111 extends from a solder mask layer 4 toward an interior of the substrate down to a surface on which the second layer pattern 102 is located. In other words, a bottom surface (that is, a surface of the interior of the substrate) of the groove 111 is coplanar with the second layer pattern 102 (ignoring a thickness of a metal of the second layer pattern). In other words, a depth of the groove 111 is equal to a distance between the first layer pattern 101 and the second layer pattern 102. On the bottom surface of the groove 111, a second conductive circuit 11 made of copper is formed in the groove, to connect to the first flip chip 2.

The first flip chip 2 includes a chip body 21 and a bump 22. The chip body 21 has a lower surface 211 and a side surface 212. The bump 22 is formed on the lower surface 211 of the chip body 21. The bump 22 may be a copper column, a tin ball, or the like.

The first flip chip 2 is mounted in the groove 111, so that the lower surface 211 of the chip body 21 is lower than an upper surface of the solder mask layer 4 of the substrate 1. In addition, a condition that a distance between the lower surface 211 and the solder mask layer 4 satisfies is as follows: A distance between the side surface 212 of the chip body 1 and the solder mask layer 4 is small enough to prevent large-sized filler particles included in a molding compound from flowing between the solder mask layer 4 and the side surface 212. Therefore, a gap 9 between the solder mask layer 4 and the side surface 212 is blocked by using the large-sized filler, thereby keeping the molding compound out of the groove 111.

In this embodiment, the second conductive circuit 11 in the groove is a part of the second layer pattern 102, which is an exposed part of the second layer pattern 102 in the groove.

To ensure that the distance between the solder mask layer 4 and the lower surface 211 satisfies the foregoing condition, a size of the bump 22 needs to match the depth of the groove 111, so that the lower surface 211 is lower than a surface of the solder mask layer 4, so that it is difficult for the molding compound to flow through the gap 9.

The film layer 6 is formed by a conventional thermoplastic material and covers upper surfaces of the solder mask layer 4, the first flip chip 2, and the second flip device 3 through a conventional vacuum film covering process. A continuous film layer 6 is formed between the chip body 21 of the first flip chip 2 and the solder mask layer 4 surrounding the chip body 21, and the film layer 6 covers (or blocks) the gap 9. Therefore, the plastic encapsulant 7 cannot enter the gap 9 and cannot enter a cavity 111. By designing the film layer 6 matching the gap 9, it can be ensured that the film layer 6 can seal the gap but does not enter the gap (or does not flow through the gap into the cavity). It can further be ensured that the film layer 6 covering the first flip chip and the solder mask layer 4 surrounding the first flip chip can withstand mold pressing, and is not cracked by the molding compound.

However, there is no continuous film layer 6 between the second flip device 3 and the solder mask layer 4 surrounding the second flip device 3. As shown in FIG. 1, the film layer between the second flip device 3 and the solder mask layer 4 near the second flip device 3 is discontinuous. In the present invention, by adjusting a distance between the second flip device 3 and the solder mask layer 4 near the second flip device 3, or by changing a thickness or a material of the film layer, the film layer 6 covering the first flip chip and the solder mask layer 4 surrounding the first flip chip can remain continuous, while the film layer 6 covering the second flip device and the solder mask layer 4 surrounding the second flip device is discontinuous or partially discontinuous.

### Second embodiment:

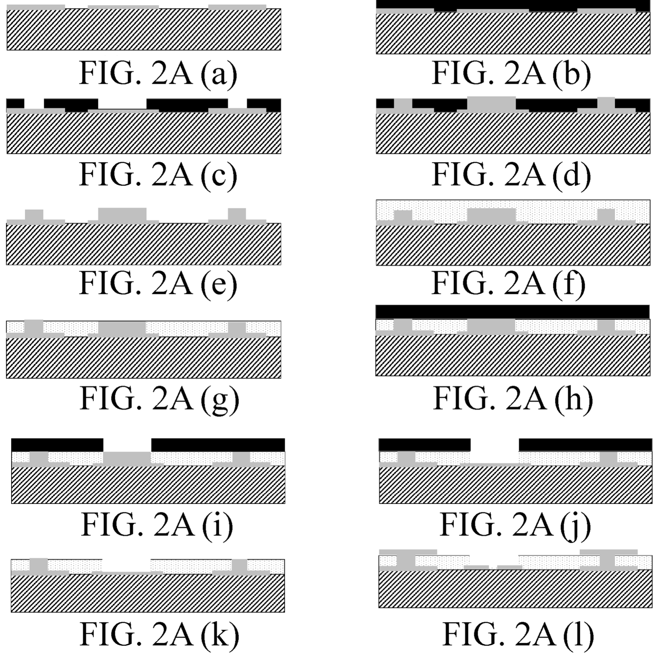

As shown in FIG. 2A to FIG. 2B, a second embodiment of the present invention provides a preparation method of a cavity filter system-in-package module, including the following steps:
S11: Prepare a substrate 1 having a groove 111, where the groove 111 extends from a solder mask layer 4 of the substrate 1 towards an interior of the substrate down to or below a layer at which a second layer pattern 102 is located.

As shown in FIG. 2A (a) to FIG. 2A (I), the substrate 1 has a groove 111 sunk to the second layer pattern 102 (in this embodiment, a second conductive circuit is used as an example for description), or a layer at which a third layer pattern is located.

In this embodiment, the groove 111 is formed by plating copper onto the inner layer substrate and then performing etching to remove a copper block. Specifically, as shown in FIG. 2A (a), the second conductive circuit (the second layer pattern 102) made of copper is formed on the inner layer substrate (for example, a PP material). Then, a film is applied and exposure and development are performed (as shown in FIG. 2A (b) and FIG. 2A (c)), to expose the conductive circuit. A copper column is formed on an exposed part of the second conductive circuit by using a plating process or the like (as shown in FIG. 2A (d)). A residual film is removed by using a film removal process (as shown in FIG. 2A (e)). Then a resin film is pressed together (as shown in FIG. 2A (f)), and the copper column is exposed by using a thinning process (as shown in FIG. 2A (g)). Subsequently, a film is applied and exposure and development are performed (as shown in FIG. 2A (h) and FIG. 2A (i)), so that the copper column located at a position of the groove (the copper column at the groove position) is exposed. Then, an etching process is used (as shown in FIG. 2A (j)), to remove the exposed copper column at the groove position, so that the second conductive circuit in the groove under the copper column at the groove position is exposed, in other words, the second conductive circuit (namely, the second layer pattern 102) is exposed in the groove. Then, the film is removed (as shown in FIG. 2A (k)), and finally, a first conductive circuit (namely, a first layer pattern 101) is formed on the resin film.

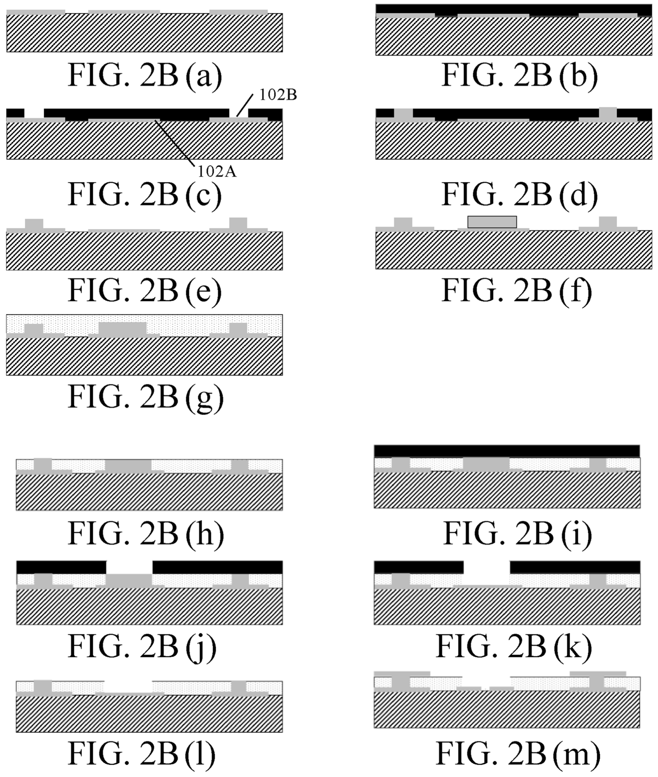

As shown in FIG. 2B (a) and FIG. 2B (b), the substrate 1 has a groove 111 sunk to the second layer pattern 102, which is formed by prepressing a copper block on the inner layer substrate and then performing etching to remove the copper block. As shown in FIG. 2B (a), a second conductive circuit (a second layer pattern 102) made of copper is formed on the inner layer substrate (for example, a PP material). Then, a film is applied and exposure and development are performed (as shown in FIG. 2B (b) and FIG.2B (c)), to expose a second conductive circuit (102B) and keep a second conductive circuit (102A) unexposed in the groove. A copper column is formed on the exposed second conductive circuit (102B) by using a plating process or the like (as shown in FIG. 2B (d)). The residual film is removed by using a film removal process (as shown in FIG. 2B (e)), so that the entire second conductive circuit is exposed (including 102A and 102B). Subsequently, a pre-made copper block is bounded to the second conductive circuit (102A) in the groove (as shown in FIG. 2B (f)). Then, a resin film is pressed together (as shown in FIG. 2B (g)), and the copper block is exposed by using a thinning process (as shown in FIG. 2B (h)). Subsequently, a film is applied and exposure and development are performed, so that a copper block located at a position of the groove (a copper block at the groove position) is exposed (as shown in FIG. 2B (i) and FIG. 2B (g)). Then, an etching process is used to remove the exposed copper block at the groove position, so that the second conductive circuit (102A) in the groove under the copper block at the groove position is exposed, in other words, the second layer pattern 102 is exposed in the groove (as shown in FIG. 2B (k)). Then, the film is removed, and finally, a first copper layer (namely, the first layer pattern 101) is formed on the resin film.

S12: Prepare a first flip chip 2 and a second flip device 3.

This is a common step, and details are not described herein.

S13: Connect a bump 22 of the first flip chip 2 to a second conductive circuit 11 in the groove, and fix the first flip chip 2 in the groove 111;

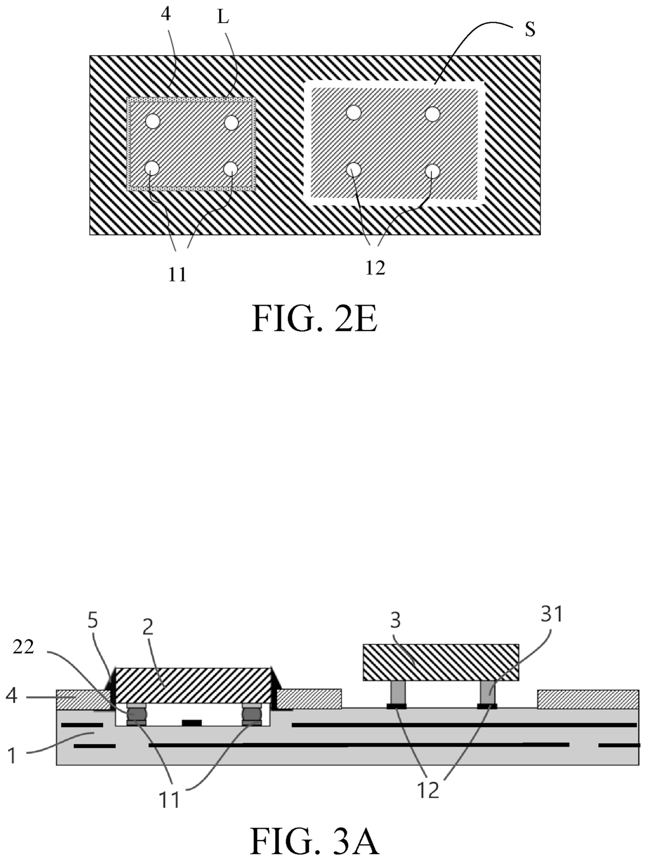

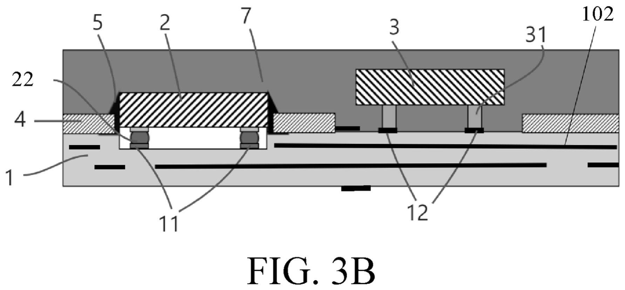

As shown in FIG. 3, because the groove 111 is coplanar with the second layer pattern 102, the first flip chip 2 is fixed to a second layer of the substrate rather than an upper surface of the substrate. However, a lower surface 211 of the first flip chip 2 is higher than the upper surface of the substrate (that is, the two are not in contact with each other).

S14: Solder the second flip device 3 to a second pad 12.

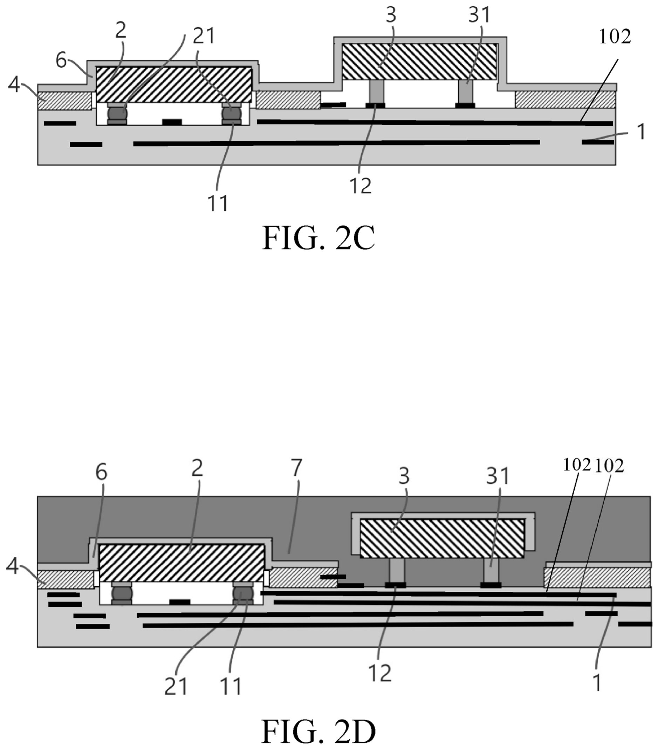

As shown in FIG. 2C, because the second pad 12 is coplanar with the first layer pattern 101, the second flip device 3 is fixed to the upper surface of the substrate.

S15: Form a solder mask layer 4 on the upper surface of the substrate 1, where the solder mask layer 4 surrounds the first flip chip 2 and the second flip device 3.

With reference to FIG. 2C and FIG. 2E, the solder mask layer 4 surrounds projection regions of the first flip chip 2 and the second flip device 3 on the substrate 1. FIG. 2E is a top view of a substrate from which the first flip chip and the second flip device are removed, and clearly shows that the solder mask layer 4 is outside the projection regions of the first flip chip and the second flip device, in other words, the solder mask layer 4 does not extend below a lower surface of the first flip chip.

As shown in FIG. 2C, a gap 9 is formed between a side surface 212 of the first flip chip and the solder mask layer 4. A size of the gap 9 (a size in a horizontal direction) satisfies the foregoing condition, so that the gap 9 is blocked by using a large-sized filler, thereby keeping the molding compound out of the groove 111, to protect the first flip chip 2 from being polluted by the molding compound.

In addition, in a horizontal direction, a distance S between the solder mask layer 4 and the second flip device 3 is greater than a size L of the gap 9, for example, S≥1.2 to 5L. The distance S between the second flip device and the substrate can be adjusted based on coordination of factors such as a height of a protrusion of the second flip device, a size of an open window of the solder mask layer, and a thickness of the solder mask layer. For example, the size L of the gap 9 needs to be controlled to be less than 15 µm; and the distance S needs to be controlled to be greater than 15 µm. Preferably, the distance S is 20 µm or even greater than 30 µm. In this way, it can be ensured that a film layer 6 can be fractured during a plastic sealing process. Preferably, the gap L is made less than or equal to a size of the filler, to ensure that the filler does not enter the gap 9.

It should be understood that step S15 may be designed to be after step S12 and before step S13. To be specific, the solder mask layer is applied before the first flip chip 2 and the second flip device 3 are fixed.

S16: Cover the solder mask layer 4, the first flip chip 2, and the second flip device 3 with the film layer 6 through a film covering process (as shown in FIG. 2C).

The gap 9 is very small and can provide sufficient support for the film layer 6. Therefore, the film layer 6 can cover the gap 9, so that the molding compound cannot enter the gap.

S17: Use a plastic sealing process to form a plastic encapsulant 7 on the film layer 7.

As shown in FIG. 2D, because the molding compound causes pressure, the film layer 6 surrounding the second flip device 3 is cracked during the plastic sealing process. During the plastic sealing process, the film layer 6 surrounding the first flip chip 2 is cracked but remains continuous and unbroken. This is because the distance S between the solder mask layer 4 and the second flip device 3 is greater than the size L of the gap 9 between the solder mask layer 4 and the first flip chip 2. The greater the distance S is, the longer a length of the film layer 6 (in a suspended state) not supported by the solder mask layer 4 is. Even under the same mold pressing, a supporting force obtained by the film layer 6 between the solder mask layer 4 and the second flip device 3 is less than a supporting force obtained by the film layer 6 between the solder mask layer 4 and the first flip chip 2. Therefore, the film layer 6 between the solder mask layer 4 and the second flip device 3 is more susceptible to be fractured under pressure.

Therefore, the film layer 6 shown in FIG. 2D obtained in this step is continuous around the first flip chip 2 and is fractured around the second flip device 3. Further, the molding compound enters between the second flip device 3 and the upper surface 100 of the substrate 1, but does not enter the groove 111 below the first flip chip.

Preferably, even if the film layer 6 surrounding the first flip chip 2 is fractured, because the gap 9 is sufficiently small, and the filler is blocked in the gap 9, the molding compound cannot enter the groove 111.

### Third embodiment:

Different from the second embodiment, this embodiment provides a preparation method of a cavity filter system-in-package module using a dispensing process. As shown in FIG. 3A and FIG. 3B, the method specifically includes the following steps:
S21: Prepare a substrate 1 having a groove 111, where the groove 111 extends from an upper surface of the substrate 1 toward an interior of the substrate down to or below a layer at which a second layer pattern 102 is located.
S22: Prepare a first flip chip 2 and a second flip device 3.
S23: Connect a bump 22 of the first flip chip 2 to a second conductive circuit 11 in the groove, and fix the first flip chip 2 in the groove 111.
S24: Solder the second flip device 3 to a second pad 12.
S25: Form a solder mask layer 4 on the upper surface of the substrate 1, where the solder mask layer 4 surrounds the first flip chip 2 and the second flip device 3.
S26: Use the dispensing process to form a colloid 5 between the first flip chip 2 and the solder mask layer 4 surrounding the first flip chip 2.
   As shown in FIG. 3A, by using the dispensing process, a part of colloid can enter the gap 9 and form the colloid 5, to implement sealing between the first flip chip 2 and the solder mask layer 4 surrounding the first flip chip 2, thereby preventing the molding compound from pouring into the groove.
S27: Use a plastic sealing process to form a plastic encapsulant 7.

As shown in FIG. 3B, because a space between the first flip chip 2 and the solder mask layer 4 around the first flip chip 2 is sealed by the colloid 5, during the plastic sealing process, the molding compound cannot be poured into the groove below the first flip chip 2 through the gap.

A space between the second flip device 3 and the solder mask layer 4 around the second flip device 3 is not sealed. Therefore, the molding compound can directly enter between the second flip device 3 and the upper surface of the substrate.

The filler particles of the plastic encapsulant 7 are large, cannot enter and fill the gap 9, and therefore, are insulated outside the first flip chip 2. A sufficient distance S is maintained between the second flip device 3 or another passive component and the substrate, so that the plastic encapsulant 7 can be filled to the bottom.

### Fourth embodiment:

Different from the first embodiment, in this embodiment, a solder mask layer is first formed, and then a first flip chip 2 and a second flip device 3 are placed. In addition, no film covering or dispensing is required, and only a sufficiently small gap 9 is used to prevent a molding compound from entering the bottom of the first flip chip.

S31: Prepare a substrate 1 having a groove 111, where the groove 111 extends from an upper surface of the substrate 1 toward an interior of the substrate down to or below a layer at which a second layer pattern 102 is located, to form a solder mask layer.

S32: Prepare the first flip chip 2 and the second flip device 3.

S33: Connect a bump 22 of the first flip chip 2 to a second conductive circuit 11 in the groove, and fix the first flip chip 2 in the groove 111, so that the solder mask layer 4 surrounds the first flip chip 2 to form a gap 9, where a size L of the gap 9 is smaller than a size of a filler in the molding compound.

S34: Solder the second flip device 3 to a second pad 12, so that the solder mask layer 4 surrounds the second flip device 3 to form a distance S, and S>L.

S35: Use the molding compound having the filler to form a plastic encapsulant 7 through a plastic sealing process.

### Fifth embodiment:

A fifth embodiment of the present invention further provides an electronic product including the foregoing cavity filter system-in-package module. The electronic product may be a wireless communication device, a wearable electronic device, an electric automobile, or the like.

It should be noted that the foregoing embodiments are merely examples for description. Technical solutions of the embodiments can be combined, and all fall within the protection scope of the present invention.

In conclusion, according to the cavity filter system-in-package module provided in the embodiments of the present invention, a filter chip can be soldered in a sink cavity formed by a solder mask layer of a substrate and a prepreg, a non-filter chip and a passive component are normally soldered on a pad of a surface layer of the substrate, and then a molding compound is used to selectively fill the non-filter chip and the passive component, to ensure that a cavity can be formed at the bottom of the filter in the module, and the bottom of the non-filter chip and the bottom of the passive component can be well filled, thereby avoiding solder-bridging and improving reliability of the cavity filter system-in-package module. In addition, a simple process in the manufacturing method results in low costs.

The foregoing describes in detail the cavity filter system-in-package module, the electronic product, and the preparation method provided in the present invention. Any obvious change made by a person of ordinary skill in the art to the present invention without departing from the essence of the present invention shall constitute a violation of the patent right of the present invention and shall take corresponding legal responsibility.

## Claims

1. A cavity filter system-in-package module, comprising a substrate, a first flip chip, a second flip device, a film layer, and a plastic encapsulant, wherein
the substrate is provided with a groove, and the groove extends from an upper surface of the substrate toward an interior of the substrate down to or below a layer at which a second layer pattern is located;
the first flip chip is mounted or soldered in the groove;
the second flip device is mounted or soldered on the upper surface of the substrate;
a solder mask layer is disposed surrounding the first flip chip and the second flip device; and
a continuous film layer is formed on the surface of the first flip chip and the solder mask layer, and a film layer on the surface of the second flip device and the solder mask layer is discontinuous.

2. The cavity filter system-in-package module according to claim 1, wherein
a gap is formed between the solder mask layer and the first flip chip, and the gap is smaller than a size of a filler in the plastic encapsulant.

3. The cavity filter system-in-package module according to claim 2, wherein
a distance is formed between the second flip device and the solder mask layer, and the distance is greater than the gap.

4. The cavity filter system-in-package module according to any one of claims 1 to 3, wherein
the distance is adjusted based on a height of a protrusion of the second flip device, a size of an open window of the solder mask layer, and a thickness of the solder mask layer.

5. The cavity filter system-in-package module according to claim 4, wherein
the distance is greater than 30 µm.

6. The cavity filter system-in-package module according to claim 1 or 2, further comprising a colloid filling the gap.

7. A preparation method of a cavity filter system-in-package module, comprising the following steps:
S11: preparing a substrate having a groove, wherein the groove extends from an upper surface of the substrate toward an interior of the substrate down to or below a layer at which a second layer pattern is located;
S12: preparing a first flip chip and a second flip device;
S13: connecting a bump of the first flip chip to a second conductive circuit in the groove, and fixing the first flip chip in the groove;
S14: soldering the second flip device to a second pad;
S15: forming a solder mask layer on the upper surface of the substrate, wherein the solder mask layer surrounds the first flip chip and the second flip device;
S16: covering the solder mask layer, the first flip chip, and the second flip device with a film layer through a film covering process; and
S17: using a plastic sealing process to form a plastic encapsulant on the film layer.

8. The preparation method of a cavity filter system-in-package module according to claim 7, wherein
in step S17, the film layer is fractured by pressure from a molding compound.

9. A preparation method of a cavity filter system-in-package module, comprising the following steps:
S21: preparing a substrate having a groove, wherein the groove extends from an upper surface of the substrate toward an interior of the substrate down to or below a layer at which a second layer pattern is located;
S22: preparing a first flip chip and a second flip device;
S23: connecting a bump of the first flip chip to a second conductive circuit in the groove, and fixing the first flip chip in the groove;
S24: soldering the second flip device to a second pad;
S25: forming a solder mask layer on the upper surface of the substrate, wherein the solder mask layer surrounds the first flip chip and the second flip device;
S26: using a dispensing process to form a colloid between the first flip chip and the solder mask layer surrounding the first flip chip; and
S27: using a plastic sealing process to form a plastic encapsulant.

10. A preparation method of a cavity filter system-in-package module, comprising the following steps:
S31: preparing a substrate having a groove, wherein the groove extends from an upper surface of the substrate toward an interior of the substrate down to or below a layer at which a second layer pattern is located, and forms a solder mask layer;
S32: preparing a first flip chip and a second flip device;
S33: connecting a bump of the first flip chip to a second conductive circuit in the groove, and fixing the first flip chip in the groove, so that the solder mask layer surrounds the first flip chip to form a gap, wherein a size L of the gap is smaller than a size of a filler in a molding compound;
S34: soldering the second flip device to a second pad, so that the solder mask layer surrounds the second flip device to form a distance S, and S>L; and
S35: using the molding compound having the filler to form a plastic encapsulant through a plastic sealing process.

11. An electronic product, comprising the cavity filter system-in-package module according to any one of claims 1 to 6.
